# EUROPÄISCHE PATENTSCHRIFT

(11) **EP 0 338 454 B1**
(45) Veröffentlichungstag und Bekanntmachung des Hinweises auf die Patenterteilung: **19.10.1994**
(21) Anmeldenummer: 89106734.0
(22) Anmeldetag: 14.04.1989
(51) Int. Cl.: H05K 13/04

(54) **Gerät zum Bestücken und/oder Verlöten bzw. Verkleben von elektronischen Bauelementen auf Leiterplatten**
Device for mounting and/or soldering or gluing electronic components on printed circuit boards
Dispositif de montage et/ou de soudage ou de collage de composants électroniques sur circuits imprimés

(30) Priorität: 19.04.1988 DE 3813097
(43) Veröffentlichungstag der Anmeldung: 25.10.1989
(73) Patentinhaber: Fritsch, Markus, D-92280 Kastl (DE)
(72) Erfinder: Fritsch, Markus, D-92280 Kastl (DE)
(74) Vertreter: Schmidt-Evers, Jürgen, Dipl.-Ing.

(56) Entgegenhaltungen:
- EP-A- 0 010 226
- DE-U- 8 508 949

## Beschreibung

Die Erfindung bezieht sich auf ein Gerät nach dem Oberbegriff des Anspruches 1 bzw. 11. Ein solches Gerät ist z.B. aus EP-A-0 010 266 bekannt.

Geräte dieser Art sind bei der Leiterplattenherstellung bzw. -reparatur in Benutzung, und sie haben sich bewährt. Es kann sich dabei um ein Gerät handeln, dessen die elektronischen Bauelemente aufnehmende Werkzeug sowohl zum Bestücken als auch Verlöten bzw. Verkleben der Bauelemente auf der Leiterplatte oder entweder zum Bestücken oder zum Verlöten bzw. Verkleben der Bauelemente auf der Leiterplatte eingerichtet ist. Beim eingangs angegebenen Gerät kann der erste Träger oder der zweite Träger verschiebbar sein, was von Hand erfolgen kann.

Bei der Bestückung von Leiterplatten ist die Identifizierung und Zuordnung der Bauelemente problematisch und zwar insbesondere dann, wenn es sich um kleine Bauelemente handelt, wie es bei sog. SMD(small mounted device)-Bauelementen der Fall ist, die meistens Abmessungen von 1mm nicht überschreiten. Selbst wenn die Bauelemente gekennzeichnet sind, ist die Identifizierung und Zuordnung schwierig und zeitraubend, und es bedarf einer besonderen Aufmerksamkeit der Bedienungsperson, um die Identifzierung und Zuordnung auszuführen.

Der Erfindung liegt die Aufgabe zugrunde, ein Gerät der eingangs bezeichneten Art so auszugestalten, daß bei Gewährleistung einer einfachen Entnahme der Bauelemente aus dem Magazin eine Verwechslung der Bauelemente weitgehend vermieden ist.

Diese Aufgabe wird durch die Merkmale der Ansprüche 1 bzw. 11 gelöst.

Bei den erfindungsgemäßen Lösungen ist gemeinsam, daß die Bauelemente in normalerweise geschlossenen Magazinkammern aufgenommen sind, die für die Entnahme der Bauelemente geöffnet und nach der Entnahme wieder geschlossen werden. Hierdurch wird sowohl eine falsche Entnahme, nämlich die Entnahme eines Bauelementes aus der nicht richtigen Magazinkammer, als auch eine Vermischung der Bauelemente mit den Bauelementen anderer Magazin-Kammern weitestgehend vermieden und somit die Gefahr einer falschen Bestückung verringert. Außerdem wird die Handhabung der Bauelemente dann erleichtert, wenn die Magazin-Kammern gemäß Anspruch 18 abnehmbar sind, wodurch ein Füllen bzw. Entleeren entfällt, da die Bauelemente in den Magazinkästen auch außerhalb des Gerätes in einfacher Weise gelagert werden können.

Bei der erfindungsgemäßen Ausgestaltung gemäß Anspruch 1 erfolgt das Öffnen der jeweils gebrauchten Magazin-Kammer in handhabungsfreundlicher Weise durch den zweiten Träger für das Bauelement. Hierdurch ist eine einfache und schnelle Entnahme möglich, weil der zugehörige Träger sowieso in die Entnahmeposition verschoben werden muß, wo das Bauelement in der Regel mittels eines speziellen Werkzeugkopfes vorzugsweise mit einer Saugnadel aus der Magazin-Kammer entnommen werden kann.

Bei der erfindungsgemäßen Lösung gemäß Anspruch 11 erfolgt das Öffnen der zugehörigen Magazin-Kammer insbesondere automatisch durch einen Öffnungsmechanismus, der dem Verschlußmechanismus der jeweils in die Gebrauchsstellung bewegten Magazin-Kammer öffnet.

Die in den Unteransprüchen enthaltenen Merkmale führen zu Verbesserungen des Gerätes bzw. Einzelteile desselben hinsichtlich einfacher Ausgestaltung, kostengünstigte Herstellung, Platzgründen und/oder rationeller Arbeitsweise. Dabei beziehen sich die erfindungsgemäßen Weiterbildungen nicht nur auf die Entnahme der Bauelemente aus den Magazin-Kammern, sondern auch auf das Bestücken bzw. Entnehmen von die Magazin-Kammern enthaltenden Magazinkästen, an hierzu vorgesehenen Trägern. Hierzu dienen vorzugsweise Schnellverschlüsse in Form von Verrastungs- oder Klemmechanismen, die eine einfache, handhabungsfreundliche und schnelle Anordnung bzw. Entfernung der Magazinkästen ermöglichen.

Nachfolgend wird die Erfindung anhand von in einer vereinfachten Zeichnung dargestellten Ausführungsbeispielen näher erläutert.

Es zeigt:
- Figur 1: ein erfindungsgemäß ausgestaltetes Gerät zum Bestücken und/oder Verlöten bzw. Verkleben von elektronischen Bauelementen auf Leiterplatten in perspektivischer Ansicht von vorne;
- Figur 2: eine Kreuzführung für einen einen Werkzeugkopf tragenden Führungsarm des Gerätes in der Draufsicht;
- Figur 3: eine erste Bremse und eine zweite Bremse für den Führungsarm im Teilschnitt III-III in Figur 2.
- Figur 4: eine Rückansicht des geöffneten Werkzeugkopfes;
- Figur 5: den Schnitt V-V in Figur 4;
- Figur 6: den Werkzeugkopf in der Vorderansicht;
- Figur 7: ein Magazin für das Gerät in der Draufsicht;
- Figur 8: den Schnitt VIII-VIII in Figur 7;
- Figur 9: einen Magazinkasten des Magazins in der Seitenansicht;
- Figur 10: einen elektrischen Schaltplan für das Gerät;
- Figur 11: ein Magazin als abgewandeltes Ausführungsbeispiel.

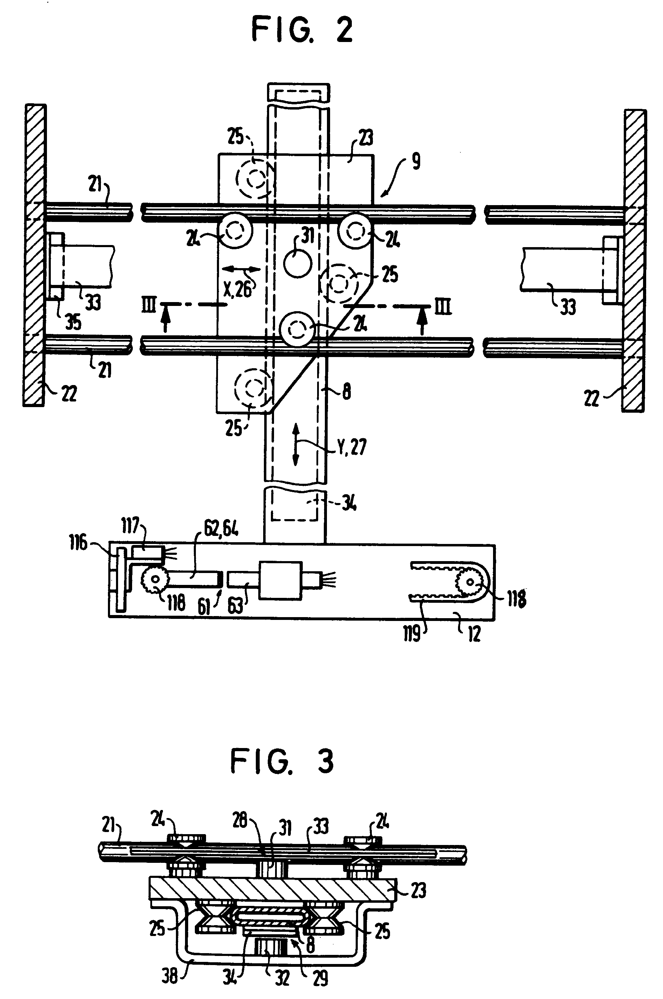

Die wesentlichen Teile des allgemein mit 2 bezeichneten Gerätes in Form eines Maniupulators sind ein Halterahmen 3 für Leiterplatten 4, der bezüglich der Bedienungsseite 5 des Gerätes 2 vorn angeordnet ist, ein bezüglich des Halterahmens 3 zur Rückseite hin versetztes, sich parallel zur Bedienungsseite 5 erstreckendes brückenförmiges Führungsteil 6, an dessen waagerechtem Holm 7 unterseitig ein Führungsarm 8 in einer in Figur 2 dargestellten Kreuzführung 9 im wesentlichen rechtwinklig und parallel zur Bedienungsseite 5 verschiebbar gelagert ist, ein am zur Bedienungsseite 5 weisenden Ende des Führungsarmes 8 angeordneter Bestückungskopf 12 mit einem Griff 13, den die Bedienungsperson zwecks wahlweiser Verschiebung des Führungsarmes 8 parallel zur Ebene der Leiterplatte 4 ergreift, ein beim vorliegenden Ausführungsbeispiel links vom Halterahmen 3 angeordnetes Magazin 14 für elektronische Bauelemente 15 und ein rechts neben dem Halterahmen 3 angeordnetes Ablagegestell 16, das zwecks Anpassung an Leiterplatten 4 unterschiedlicher Größe längs der Bedienungsseite 5 auf einem den Halterahmen 3 tragenden Gestell 17 verschiebbar geführt ist, und auf den die den Bestückungskopf 12 führende Hand der Bedienungsperson abgestützt werden kann.

An der Frontseite des Holmes 7 sind die Funktion des Gerätes bestimmende Steuerelemente angeordnet.

Die Bewegungskoordinaten des Führungsarmes 8, auf denen das vom Werkzeugkopf 12 getragene Bestückungs-Werkzeug, das beim vorliegenden Ausführungsbeispiel eine Saugnadel 18 ist, in der Ebene der Leiterplatte 4 an jede Stelle im Koordinatensystem, d.h. an jede Stelle der Leiterplatte 4, verschoben werden kann, sind mit X und Y bezeichnet.

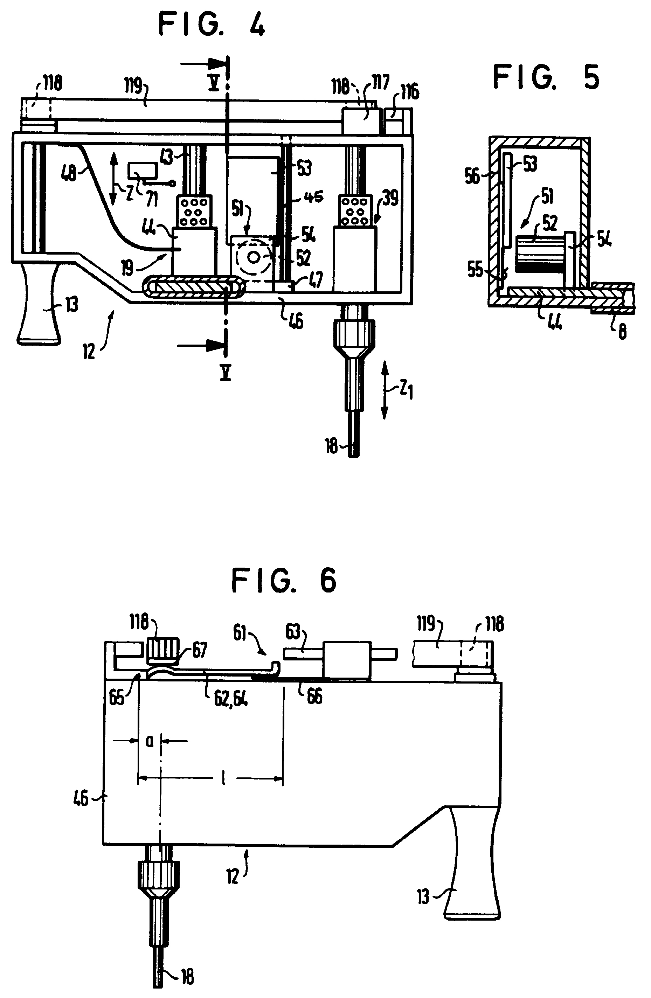

Es ist eine weitere senkrechte Bewegungsrichtung Z für das Bestückungswerzeug vorgesehen, die beim vorliegenden Ausführungsbeispiel durch eine senkrechte Führung 19 (Fig. 4) zwischen dem Führungsarm 8 und dem Bestückungskopf 12 gebildet ist.

Die wesentlichen Teile der in Figur 2 dargestellten Kreuzführung 9 sind zwei Führungsschienen 21 in Form von Rundstangen, die sich parallel zur Achse X in horizontaler Ebene erstrecken und an den Seitenwangen 22 des Führungsteils 6 befestigt sind, eine Führungsplatte 23, die sich zwischen den Führungsschienen 21 und dem Führungsarm 8 erstreckt (Figur 3) und jeweils drei Führungsrollen 24,25, von denen die mit 24 bezeichneten Führungsrollen mit den Führungsschienen 21 zusammenwirken und die X-Führung 26 ergeben, während die mit 25 bezeichneten Führungsrollen mit dem Führungsarm 8 zusammenwirken und die Y-Führung 27 ergeben. Wie insbesondere aus Figur 3 ersichtlich ist, weisen die Führungsrollen 24,25, eine X-förmige Mantelfläche auf, mit der sie die Führungsschienen 21 und den seitlich gerundeten Führungsarm 8 umgreifen, so daß die Führung in der Horizontalen gesichert ist. Der Führungsarm 8 besteht aus einem abgeflachten Rohr, d.h. er weist ebene Ober- und Unterseiten sowie gerundete Seitenflächen auf. Die Führungsrollen 24,25 umgreifen die Führungsschienen 21 bzw. den Führungsarm 8 jeweils an drei Punkten, wodurch auf einfache Weise eine exakte Führung gewährleistet ist.

Der Kreuzführung 9 sind zwei Bremsen 28,29 zugeordnet, von denen die Bremse 28 eine wahlweise Blockierung der Bewegung der Führungsplatte 23 in der X-Richtung und die Bremse 29 eine wahlweise Blockierung der Bewegung des Führungsarmes 8 in der Y-Richtung ermöglicht. Die Bremsen 28,29 sind Elektromagnetbremsen mit jeweils einem Elektromagneten 31,32 und einem zugehörigen Bremselement, das beim vorliegenden Ausführungsbeispiel stangenförmig ausgebildet ist, nämlich ein Metallband 33,34 aus ferromagnetischem Material, das sich längs der X- bzw. Y-Richtung erstreckt. Die Bremsen 28,29 sind im einzelnen in der Figur 3 erkennbar. Das Metallband 33 der X-Bremse 28 ist mittels Befestigungswinkeln 35 an den Seitenwangen 22 befestigt, während das Metallband 34 der Y-Bremse 29 an der Unterseite des Führungsarmes 8 vorzugsweise durch an den freien Enden des Metallbandes 34 angeordnete Schrauben befestigt ist. Die Metallbänder 33,34 bestehen jeweils aus zwei übereinander angeordneten Flachbändern zwischen denen eine Dämmschicht bzw. ein Dämmstreifen aus weichem bzw. zähem oder elastischem Material. Beim vorliegenden Ausführungsbeispiel ist ein doppelseitig klebender Klebestreifen vorzugsweise aus Kunststoff oder Papier angeordnet und vorzugsweise mit den Flachbändern 36 verklebt ist. Hierdurch werden Vibrationen und die Erzeugung von akustischen Tönen beim Anschlagen der Bremse vermieden.

Da die Metallbänder 33,34 in ihrer Längsrichtung unnachgiebig sind bzw. unnachgiebig gehalten sind, führt jeweils eine Betätigung der Bremse 28,29, durch Schließen eines nicht dargestellten elektrischen Kreislaufs, in dem der zugehörige Elektromagnet 31,32 angeordnet ist, zu einer exakten Fixierung des Führungsarms 8 bzw. des Bestückungskopfes 12 in der jeweiligen Bewegungsrichtung. Von Bedeutung ist auch, daß die Elektromagneten 31,32 jeweils an der unteren Seite des zugehörigen Metallbandes 33,34 angeordnet sind, wodurch auf Verschmutzungen beruhende Funktionsstörungen der Bremsen 28,29 verhindert sind. Beim vorliegenden Ausführungsbeispiel ist der Elektromagnet 31 der X-Bremse 28 auf der Führungsplatte 23 angeordnet, während der Elektromagnet 32 der Y-Bremse 29 unterhalb des Führungsarmes 8 auf einem letzteren untergreifenden U-Bügel 38 angeordnet ist, der an der Unterseite der Führungsplatte 23 durch Schrauben befestigt ist.

Das durch die Saugnadel 18 gebildete Bestückungs-Werkzeug ist in der allgemein mit 19 bezeichneten senkrechten Z-Führung durch ein senkrechtes Verschieben des Bestückungskopfes 12 verschiebbar. Außerdem ist die Saugnadel 18 im Bestückungskopf 12 in einer mit 39 bezeichneten senkrechten Führung um vorzugsweise nur einige Millimeter verschiebbar, was durch den Doppelpfeil Z₁ verdeutlicht ist.

Beide senkrechte Führungen 19,39 sind Wälzlagerführungen und somit von hoher Präzision. Die Z-Führung 19 weist eine senkrechte runde Führungsstange 43 auf, die mit einem Wälzlagerkäfig in einem am Führungsarm 8 befestigten senkrechten Führungsstück 44 verschiebbar ist. Zwecks Vermeidung einer horizontalen Verdrehung des Bestückungskopfes 12 um die Führungsstange 43 ist eine zweite senkrechte Führungsstange 45 im kastenförmigen Gehäuse 46 des Bestückungskopfes 12 angeordnet, die von einem seitlichen Ansatz 47 des Führungsstückes 44 ebenfalls mit Präzision gabelförmig umgriffen wird. Mittels einer zwischen dem Führungsstück 44 oder Anbauteilen und dem Gehäuse 46 wirksamen Blattfeder 48 wird der Bestückungskopf 12 in seine obere Endstellung beaufschlagt.

Der senkrechten Führung 19 ist ebenfalls eine allgemein mit 51 bezeichnete Bremse zugeordnet, die ebenfalls eine an einen nicht dargestellten Stromkreislauf angeschlossene Elektromagnetbremse mit einem Elektromagneten 52 und einer Bremsfläche aus ferromagnetischem Material, die beim vorliegenden Ausführungsbeispiel ebenfalls an einem Metallband angeordnet ist, das längs des Elektromagneten 52 beweglich gehalten ist, so daß letzterer unbeweglich angeordnet werden kann. Beim vorliegenden Ausführungsbeispiel ist der Elektromagnet 52 an einem Halter 54 befestigt, der am vom Führungsstück 44 ausgehenden Ansatz 47 befestigt ist. Das Metallband ist ein Plättchen 53, das in senkrechter Position mittels einer an ihm befestigten Blattfeder 55 an der Seitenwand 56 des Gehäuses 46 so befestigt ist, daß es längs des Elektromagneten 52 auslenkbar ist, um bei Beaufschlagung des Elektromagneten 52 spaltfrei an dessen Stirnseite anzuliegen. Bei allen Bremsen 28,29,51 ist die Anordnung so getroffen, daß zwischen dem Elektromagneten 31,32,52 und den zugehörigen Metallbändern 33,34 bzw. Plättchen 53 ein kleiner Luftspalt vorhanden ist. Hierdurch werden Schleifgeräusche vermieden, wenn der Bestückungskopf 12 im gelösten Zustand der Bremsen verstellt wird.

Dem durch die Saugnadel 18 gebildeten Bestückungswerkzeug ist ein Schalter 61 (Fig. 6) beim vorliegenden Ausführungsbeispiel an der Oberseite des Bestückungskopfes 12 angeordnet, der nahe der obersten Position der Saugnadel 18 in der mit Z₁ bezeichneten Bewegungsrichtung betätigt wird. Es handelt sich um einen sog. Übersetzungsschalter, um zu erreichen, daß die Schaltung mit einer möglichst kleinen Bewegung der Saugnadel 18 in der Z₁-Bewegungsrichtung erreicht wird. Der Schalter 61 ist ein berührungsloser Schalter mit einem beweglichen Schaltelement 62 und einem stationären Schaltelement 63. Das bewegliche Schaltelement 62 ist in Form eines hier einarmigen Hebels 64 bei 65 vertikal schwenkbar gelagert, das mittels einer Feder, vorzugsweise einer Blattfeder 66, in seine Kontaktstellung mit dem stationären Schaltelement 63 beaufschlagt ist. Die durch Eigengewicht oder durch Federkraft sich normalerweise in ihrer unteren Stellung befindliche Saugnadel 18 drückt mit einem Betätigungsglied 67 normalerweise auf den Hebel 64, wodurch der Schalter 61 geöffnet wird. Sobald die Saugnadel 18 geringfügig angehoben wird, wird der Schalter 61 mittels der Blattfeder 66 geschlossen. Da der Abstand a der Saugnadel 18 vom Lagerpunkt 65 des Hebels 64 viel kleiner ist als die Länge 1 des Hebels 64, vorzugsweise etwa nur 1/5 der Länge 1 beträgt, genügt schon eine geringe senkrechte Bewegung der Saugnadel 18, um den berührungslosen Schalter 61 zu betätigen.

Dem Bestückungskopf 12 ist im Bereich der Z-Führung 19 ein zweiter, andeutungsweise dargestellter Schalter 71, Fig. 4 zugeordnet, der in einem Bereich zwischen der untersten und der obersten Position des Bestückungskopfes 12 (vorzugsweise im mittleren Bereich) zwischen diesen Positionen, die Funktion der Bremsen 28,29,51 unterbindet. Dieser Schalter wird durch zwei relativ zueinander verstellten Führungsstück der Z-Führung, hier durch das Gehäuse 46, an dem der Schalter 71 befestigt ist, und das Führungsstück 44 betätigt.

Das Magazin 14 umfaßt eine Magazinstange 81 in Form einer Profilschiene mit einer Mehrzahl von Magazinkästen 82, die - da das vorliegende Gerät zum Bestücken von kleinen SMD-Bauelementen 15 bestimmt ist - verhältnismäßig klein ausgebildet sind. Es handelt sich um mittels eines Deckels, vorzugsweise eine Klappdeckels 83, wahlweise zu öffnende und zu schließende Magazinkästen 82, die nur für den kurzen Zeitabschnitt der Bestückung geöffnet werden. Hierdurch wird vermieden, daß Bauelemente 15 unabsichtlich in falsche Magazinkästen 82 geraten, wodurch hierdurch hervorgerufene Fehlbestückungen ausgeschlossen werden.

Das Magazin 14 ist in der Nähe des Halterahmens 3 für die Leiterplatten 4 angeordnet, um lange Transportwege für die Bauelemente 15 zwischen dem Magazin 14 und der Leiterplatte 4 möglichst zu vermeiden. Beim vorliegenden Ausführungsbeispiel befindet sich das Magazin 14 links neben dem Halterahmen 3. Es könnte jedoch auch rechts neben und/oder vor bzw. hinter dem Halterahmen 3 angeordnet sein.

Zur Halterung des Magazins 14, hier der Magazinstange 81, ist ein Magazinhalter 84 am Gestell 17 angeordnet, der in vergleichbarer Weise wie der Halterahmen 3 zwei horizontale Halteleisten 85 aufweist, von denen eine vorzugsweise entweder in Form einer Klemmleiste 86 ausgebildet ist oder eine solche aufweist. Zwischen den Halteleisten 85 ist die Magazinstange 81 eingesetzt und mittels der Klemmleiste 86 nachgiebig gehalten. Die Anordnung ist so getroffen, daß der Boden 87 der Magazinkästen 82 sich etwa in Höhe der gehaltenen Leiterplatte 4 befindet.

Der sich jeweils an der Oberseite des zugehörigen Magazinkastens 82 befindliche Klappdeckel 83 ist auf der der Leiterplatte 4 abgewandten Seite des Magazinkastens 82 um ein im wesentlichen horizontales Gelenk 88 schwenkbar gelagert, wobei er auf der der Leiterplatte 4 zugewandten Seite einen Verschlußmechanismus, vorzugsweise in Form eines Rastverschlusses 89 aufweist. Dieser Rastverschluß 89 ist manuell, vorzugsweise mit Hilfe des Bestückungswerkzeugs, hier der Saugnadel 18, zu öffnen. Der Rastverschluß 89 weist eine Verrastungsnase 91 auf, die beim vorliegenden Ausführungsbeispiel an einem sich im wesentlichen vertikal erstreckenden Verrastungsarm 92 angeordnet ist, der durch seitliches Wegdrücken aus seiner Verrastungsstellung verstellbar ist und durch Federkraft oder vorzugsweise elastisch in seine Verrastungsstellung zurückgestellt wird, in der er mit seiner Verrastungsnase 91 eine Verrastungskante bzw. -fläche am Klappdeckel 83, hier die Oberseite übergreift. Beim vorliegenden Ausführungsbeispiel weist die Verrastungsnase 91 oberseitig eine Schrägfläche 93 auf, die zur der Leiterplatte 4 abgewandten Seite hin geneigt ist. Der Rastverschluß 89 kann somit mit der Saugnadel 18 entweder durch eine senkrechte Bewegung nach unten oder eine horizontale Bewegung der Saugnadel 18 in Richtung auf die Leiterplatte 4 durch Drücken gegendie Verrastungsnase 91 geöffnet werden, wobei der Klappdeckel 83 nach Lösung der Verrastungsnase 91 automatisch im Sinne eines Sprungdeckels aufspringt.

Um das Öffnen mittels der Saugnadel 18 zu erleichtern, weist der Klappdeckel 83 neben der Verrastungsnase 91 und zwar auf deren der Leiterplatte 4 abgewandten Seite eine Ausnehmung 94 auf, die schmaler bemessen ist, als die Verrastungsnase 91, so daß letztere die Ränder der Ausnehmung 94 zu übergreifen vermag.

Die Magazinkästen 82 bestehen vorzugsweise aus Kunststoff. Beim vorliegenden Ausführungsbeispiel ist der Verrastungsarm 92 einstückig an der zugehörigen Seitenwand des Magazinkastens 82 angeformt und zwar vorzugsweise in Form eines doppelarmigen Hebels, so daß die Verrastungsnase 91 wahlweise durch eine Beaufschlagung des oberen oder unteren Hebelarmes 92.1 zu betätigen ist (Zug- oder Druckbetätigung). Beim vorliegenden Ausführungsbeispiel ist der Verrastungsarm 92 im mittleren Bereich durch Verbindungsstücke 96 mit der Seitenwand 95 verbunden, um die er im Sinne eines Gelenkes 97 mit horizontaler Achse schwenkbar ist. Um die freie Schwenkbarkeit zu gewährleisten, sind innenseitig vom Verrastungshebel und seitlich Ausnehmung 98,99 vorgesehen. Bei dem Magazinkasten 82 handelt es sich um ein Kunststoffspritzteil.

An der Unterseite des Magazinkastens 82 sind krallenförmige Klemmelemente 101 mit Klemmnasen 102 vorgesehen, die seitliche Hinterschneidungen an der Magazinstange 81 hintergreifen. Die Hinterschneidungen sind durch Schrägflächen 103 gebildet, die aufgrund ihrer schrägen Lage ein bequemes Entfernen der Magazinkästen 82 ermöglichen, indem letztere mit einem geringen Kraftaufwand einfach nach oben abgezogen werden, wobei die Klemmelemente 101 nach außen gedrückt werden. Um das Aufklipsen der Magazinkästen 82 auf die Magazinstange 81 ebenfalls zu erleichtern, sind oberseitig der Schrägflächen 103 weitere Schrägflächen 104 dachförmig angeordnet, mittels denen die Klemmelemente 101 beim Aufklipsen auseinandergedrückt werden.

Beim vorliegenden Ausführungsbeispiel sind die Magazinkästen 82 einreihig angeordnet, mittels einer Magazinstange 81. Es ist auch möglich, die Magazinkästen 82 bzw. -stangen zwei- oder mehrreihig anzuordnen, wobei eine entssprechende Anzahl Magazinhalter 84 vorgesehen werden müßten.

Zum Bestücken einer Leiterplatte 4 ist diese im Halterahmen 3 zu haltern. Der Halterahmen 3 weist hierzu zwei weitere, sich quer zur Bedienungsseite 5 erstreckende Halteleisten 85 auf, von denen die linke Halteleiste starr und die rechte Halteleiste 85 in einer sich parallel zur Bedienungsseite 5 erstreckenden Führung bzw. auf einer diese Führung bildenden Führungsschiene 113 verschiebbar und mittels einer Feststellschraube 120 wahlweise feststellbar ist. Die oberen Ränder der Halteleisten 85 sind einander spiegelbildlich gestuft, so daß sich Auflager für die Leiterplatte 4 und letztere seitliche übergreifende Begrenzungsstege ergeben.

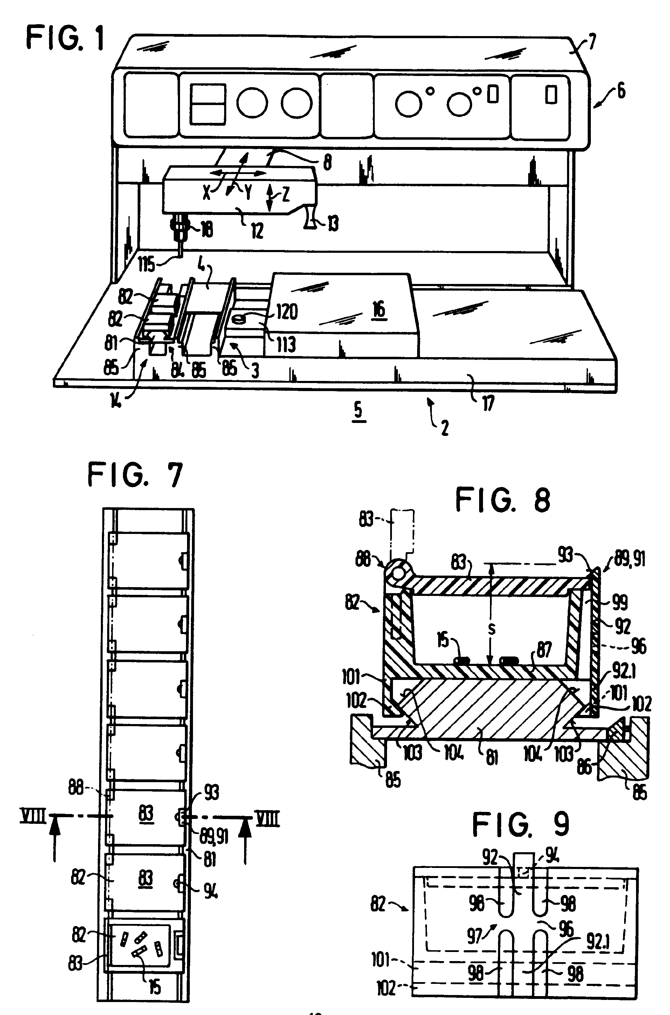

Beim vorliegenden Ausführungsbeispiel ist das Bestückungswerkzeug am Bestückungskopf 12 eine Saugnadel, mittels der ein Bauelement 15 aus dem Magazin 14 entnommen und auf der Leiterplatte 4 an der vorbestimmten Stelle abgesetzt wird. Hierzu ist nach dem Einschalten einer nicht dargestellten Luft-Saugpumpe, die durch eine Schlauchleitung mit der Saugnadel 18 verbunden ist, die Saugnadel zu einem das vorbestimmte Bauelement 15 enthaltenden Magazinkasten 82 zu führen, von denen in Figur 1 aus Vereinfachungsgründen nur zwei Stück dargestellt sind. Die Bewegung der Saugnadel 18 erfolgt dabei durch wahlweises Verschieben des Bestückungskopfes 12 in den drei schon beschriebenen Bewegungsrichtungen X,Y und Z. Das Öffnen des vorbestimmten Magazinkastens 82 erfolgt mittels der Saugnadel 18, wozu letztere entweder von oben nach unten gegen die Schrägfläche 93 oder von der Seite her gegen die Verrastungsnase 91 bzw. den Verrastungsarm 92 zu verschieben ist. Sobald die Verrastung aufgehoben ist, springt der betreffende Klappdeckel 83 auf und die Saugnadel 18 kann in den geöffneten Magazinkasten 82 abgesenkt werden, um ein Bauelement 15 mittels der Saugluft an der Saugspitze 115 der Saugnadel aufzunehmen. Dann wird die Saugnadel über die Leiterplatte 4 gefahren und durch Verschieben nach unten des Bestückungskopfes 12 an der bestimmten Bestückungsstelle aufgesetzt. Sobald das Bauelement 15 auf die Leiterplatte 4 aufgesetzt wird, ergibt sich durch weiteres, geringes Verschieben des Bestückungskopfes 12 nach unten eine Relativverschiebung zwischen der Saugnadel 18 und dem Bestückungskopf 12, wobei letzterer gegenüber ersterer nach unten verschoben wird. Bei dieser Bewegung wird das Schaltelement 62 durch die Saugnadel 18 nach oben verstellt, wodurch der Schalter 61 geschlossen wird, der die Bremsen 28,29 in Funktion setzt und die Saugluft an der Saugspitze 115 abstellt. Aufgrund der Betätigung der Bremsen 28,29 ist die Saugnadel 18 in der horizontalen Ebene fixiert, so daß ein seitliches Verstellen oder Verrutschen aus dieser Bestückungsposition nicht mehr möglich ist.

Durch Betätigung eines kippbaren Schaltgliedes 116 eines Schalters 117, der beim vorliegenden Ausführungsbeispiel ebenfalls an der Oberseite des Bestückungskopfes 12 angeordnet ist und zwar oberhalb der Saugnadel 18, läßt sich auch die dritte Bremse 51 einschalten, wodurch die Saugnadel 18 in allen Bewegungsrichtungen X,Y,Z arretiert ist. In dieser Position übt die Saugnadel eine Haltefunktion auf das zwischen ihrer Spitze und der Leiterplatte 4 befindlichen Bauelement 15 aus. Dies ist insbesondere in solchen Fällen vorteilhaft, in denen das Bauelement durch eine weitere manuelle Handhabung an der Leiterplatte 4 befestigt werden soll, wie insbesondere Löten und Verkleben. Aufgrund der Arretierung der Saugnadel 18 auch in der senkrechten Z-Bewegungsrichtung braucht der Bestückungskopf 12 nicht mehr von Hand gehalten zu werden und die Bedienungsperson hat deshalb beide Hände frei, um z.B. mit der einen Hand das Lötzinn und mit der anderen Hand einen Lötkolben zu führen.

Durch erneute manuelle Betätigung des Schaltgliedes 116 kann der Schalter 117 und somit auch die in der senkrechten Z-Bewegungsrichtung wirksame Bremse 51 ausgeschaltet werden, wonach der Bestückungskopf hochgeschoben werden kann, bzw. durch die Kraft der Blattfeder 66 hochgeschoben wird. Gleichzeitig, d.h. bei der dabei erfolgenden Relativbewegung zwischen dem Bestückungskopf 12 und der Saugnadel 18 wird die Betätigung des Schalters 61 aufgehoben und somit werden auch die Bremsen, 28,29 gelöst, so daß ein neuer Bestückungs- bzw. Reparaturvorgang erfolgen kann. Die Saugluftschaltung zur Aufnahme eines Bauelementes von der Leiterplatte 4 (Reparatur) oder eines nächsten Bauelementes 15 aus dem Magazin 14 erfolgt automatisch durch leichtes Drücken der Saugnadel 18 gegen das Bauelement, wodurch der Schalter 61 betätigt wird und die Saugluft einschaltet.

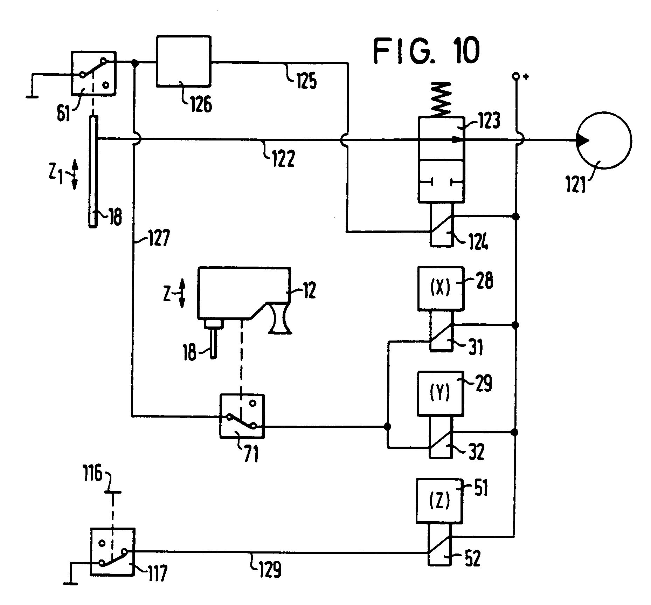

Beim Öffnen des Deckels 83 wird die Saugnadel 18 in der Regel eingeschoben und der Schalter 61 betätigt. Um hier das Einschalten der Bremsen 28,29 zu verhindern, ist der dies gewährleistende Schalter 71 an die durch die Magazinkastenhöhe vorgegebene Stufe S (Fig. 8) anzupassen. Das heißt, beim vorliegenden Ausführungsbeispiel ist die Einschaltung der Bremsen 28,29 und die Abschaltung der Saugluft nur bei betätigtem Schalter 71, d.h. im unteren Bereich der Z-Bewegung, möglich.

Wie aus den Fig. 2, 4 und 6 zu entnehmen ist, kann die Saugnadel 18 und somit auch das von ihr getragene Bauelemente 15 um die Längsachse der Saugnadel 18 wahlweise gedreht werden. Hierzu ist sowohl die Saugnadel 18 und auch der Griff 13 um seine vertikale Achse drehbar im Bestückungskopf gelagert, wobei zwischen den oberen Enden der Saugnadel 18 und der den Bestückungskopf 12 durchfassenden Welle des Griffs 13 ein Drehantrieb, vorzugsweise ein Riementrieb mit Riemenscheiben 118 und einem Riemen 119, vorzugsweise ein Zahnriemen, zugeordnet ist.

Wie der Schaltplan gemäß Fig. 10 zeigt, ist in der von einer Vakuumquelle 121 zur Saugnadel 18 führenden Saugleitung 122 ein elektromagnetisch betätigbares Absperrventil 123 angeordnet, dessen Elektromagnet 124 durch eine elektrische Leitung 125 mit dem Schalter 61 verbunden ist, wobei in der Leitung 125 - je nach Ausführung des Schaltkreises als einfacher elektrischer Schaltkreis oder als elektronischer Schaltkreis - ein Wechselschalter 126 oder ein Flip-Flop angeordnet ist. Hierdurch wird bei einander nachfolgenden Betätigungen des Schalters 61 der Wechselschalter 126 wechselweise umgeschaltet, so daß die Saugluft wechselweise zu- und abgeschaltet wird. Zwischen den Schaltern 61 und 126 zweigt eine elektrische Leitung 127 ab, in der der Schalter 71 angeordnet ist, und in deren weiteren Verlauf die Elektromagneten 31 und 32 der Bremsen 28 und 29 in Parallelschaltung angeordnet sind. Der Schaltplan zeigt die Saugnadel 18 in angehobener Position (Schalter 61 ist geschlossen) und den Bestückungskopf 12 in herabgesenkter Position, so daß das Schließen der Bremsen 28,29 möglich ist. In der angehobenen Position des Bestückungskopfes 12 ist ein Schließen der Bremsen 28,29 wunschgemäß nicht möglich. Das Schließen und Öffnen der Bremsen 28,29 ist somit abhängig in erster Abhängigkeit vom Schalter 71 und in zweiter Abhängigkeit vom Schalter 61 und unabhängig von der Stellung des Wechselschalters 126. Dagegen kann die in der vertikalen Z-Bewegungsrichtung wirksame Bremse 51 unabhängig von den vorbeschriebenen Betriebszuständen durch manuelle Betätigung des Schalters 117 wahlweise geschlossen und geöffnet werden. Der Elektromagnet 52 der Bremse 51 ist in einer vom Schalter 117 führenden elektrischen Leitung 129 angeordnet.

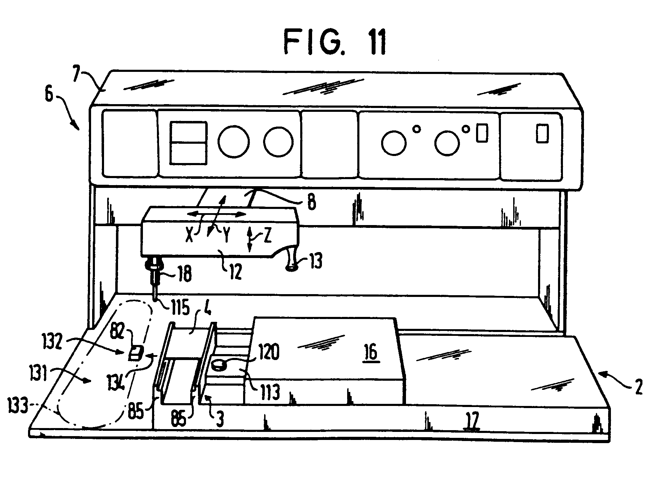

Das Ausführungsbeispiel gemäß Figur 11 unterscheidet sich von den vorbeschriebenen dadurch, daß die hier mit 82 bezeichneten Magazinkästen des Magazins 131 nicht mittels der Saugnadel 18, sondern automatisch geöffnet werden. Dies wird dadurch erreicht, daß die Magazinkästen 82, von denen nur einer dargestellt ist, des hier mit 131 bezeichneten Magazins zur Entnahme eines oder mehrerer Bauelemente 15 in eine Gebrauchsstellung verstellt und in dieser allgemein mit 132 bezeichneten Gebrauchsstellung automatisch geöffnet werden. Beim vorliegenden Ausführungsbeispiel sind die Magazinkästen 82 auf einen Transportelement, z.B. einem Förderband 133, umlaufend angeordnet. Direkt vor oder in der Gebrauchsstellung 132 wird jeweils der Verschlußmechanismus geöffnet. Dies kann durch einen Anschlag erfolgen oder beim vorliegenden Ausführungsbeispiel durch ein Druckstück 134, das entweder gesondert betätigt wird oder in die Bewegungsbahn der Magazinkästen 82 hineinragt. Beim vorliegenden Ausführungsbeispiel ist ein nachgiebiges Druckstück 134 angeordnet, auf das in der Gebrauchsstellung der Verrastungsarm 92.1 trifft und durch das Drückstück 134 zur Lösung der Klappdeckel-Verrastung betätigt wird, wobei der Klappdeckel 83 aufspringt. Da das Druckstück 134 nachgiebig gelagert ist, kann es ohne weiteres durch die zugehörige Seitenwand des betreffenden Magazinkastens 82 eingedrückt werden. wobei es bei Kontakt mit dem Verrastungsarm 92.1 aufgrund seiner Vorspannkraft vorgedrückt wird und die Öffnung des Klappdeckels 82 auslöst.

Bei beiden vorbeschriebenen Ausführungsbeispielen werden der Klappdeckel 82 nach Entnahme der erforderlichen Bauelemente 18 von Hand wieder geschlossen. Letzteres kann insbesondere beim zweiten Ausführungsbeispiel gemäß Figur 11 auch automatisch erfolgen und zwar insbesondere während der Fortbewegung des betreffenden Magazinkastens 82 aus der Gebrauchsstellung 132. Bei diesem Ausführungsbeispiel ist der Schalter 71 nicht notwendig.

In seinen weiteren Einzelheiten entspricht das zweite Ausführungsbeispiel gemäß Figur 11 dem ersten Ausführungsbeispiel gemäß Figuren 1 bis 10, so daß auf eine weitere Funktionsbeschreibung verzichtet werden kann.

## Patentansprüche

1. Gerät (2) zum Bestücken und/oder Verlöten bzw. Verkleben von elektronischen Bauelementen (15), insbesondere SMD-Bauelementen, auf Leiterplatten (4), mit einem ersten Träger (3) für wenigstens eine Leiterplatte (4), mit einem zweiten Träger (12,18) für das Bauelement (15), und mit einem Magazin (14) für die Bauelemente (15), das Kammern (82) zur Aufnahme der Bauelemente (15) aufweist, wobei der zweite Träger (12,18) und das Magazin (14) relativ zueinander verstellbar sind,
**dadurch gekennzeichnet,**
daß die Kammern (82) durch einen Deckel (83) mit einem Verschlußmechanismus (89) zu öffnen und zu schließen sind und der Verschlußmechanismus (89) durch den Träger (12,18) für das Bauelement (15) zu öffnen ist.

2. Gerät nach Anspruch 1, dadurch gekennzeichnet, daß der Deckel (82) in seiner Verschlußstellung durch ein Verrastungsglied (91) verrastbar ist, daß durch den Träger (12,18) aus seiner Verrastungsstellung herausbewegbar ist.

3. Gerät nach Anspruch 1 oder 2, dadurch gekennzeichnet, daß der erste Träger (3) und der zweite Träger (12,18) parallel zur Ebene der Leiterplatte (4) und quer dazu relativ zueinander verstellbar sind.

4. Gerät nach einem der vorherigen Ansprüche, dadurch gekennzeichnet, daß das Verrastungsglied (91) durch eine vertikale Bewegung des zweiten Trägers (12,18) aus seiner Verrastungsstellung herausbewegbar ist.

5. Gerät nach Anspruch 4, dadurch gekennzeichnet, daß das Verrastungsglied (91) durch eine von oben zugängliche Schrägfläche (93) zu seiner Betätigung aufweist.

6. Gerät nach einem der Ansprüche 2 bis 5, dadurch gekennzeichnet, daß das Verrastungsglied (91) im wesentlichen horizontal bewegbar ist.

7. Gerät nach einem der vorherigen Ansprüche dadurch gekennzeichnet, daß die Kammern an vorzugsweise untereinander gleichen abnehmbaren Magazinkästen (82) ausgebildet sind.

8. Gerät nach Anspruch 7, dadurch gekennzeichnet, daß die Magazinkästen (82) an einem weiteren Träger (14,81) am Gerät (2) vorzugsweise durch Klemmen oder Verrasten festlegbar sind.

9. Gerät nach Anspruch 8, dadurch gekennzeichnet, daß vorzugsweise mehrere Magazinkästen (82) an einem Tragteil, insbesondere einer Tragschiene, festlegbar sind, das am weiteren Träger (81) befestigbar ist.

10. Gerät nach Anspruch 9, dadurch gekennzeichnet, daß das Tragteil am weiteren Träger (14,81) durch Verrasten oder Klemmen befestigbar ist, bzw. sind.

11. Gerät (2) zum Bestücken und /oder Verlöten bzw. Verkleben von elektronischen Bauelementen (15), insbesondere SMD-Bauelementen, auf Leiterplatten (4), mit einem ersten Träger (3) für wenigstens eine Leiterplatte (4), mit einem zweiten Träger (12,18) für das Bauelement (15),
und mit einem Magazin (131) für die Bauelemente (15), das Kammern zur Aufnahme der Bauelemente (15) aufweist, wobei der zweite Träger (12,18) und das Magazin (131) relativ zueinander verstellbar sind, oder Gerät (2) nach einem der vorherigen Ansprüche,
**dadurch gekennzeichnet,**
daß die Kammern durch Magazinkästen (82) mit einem durch einen Verschlußmechanismus (89) zu öffnenden und verschließbaren Deckel (83) gebildet sind, daß die Magazinkästen (82) auf einer Bewegungsbahn (133) in eine Gebrauchsstellung (132) verstellbar sind, und daß in der Gebrauchsstellung (122) des jeweiligen Magazinkastens (82) ein Öffnungsmechanismus (124) für den Deckel (83) vorgesehen ist.

12. Gerät nach Anspruch 11, dadurch gekennzeichnet, daß der Deckel (83) in der Gebrauchsstellung automatisch öffnet.

13. Gerät nach einem der vorherigen Ansprüche, dadurch gekennzeichnet, daß der Deckel durch Federkraft in seine Offenstellung vorgespannt ist.

14. Gerät nach einem der vorherigen Ansprüche, dadurch gekennzeichnet, daß der Deckel (83) in seiner Verschlußstellung verrastbar ist.

15. Gerät nach einem der vorherigen Ansprüche, dadurch gekennzeichnet, daß der Deckel ein Klappdeckel ist.

16. Gerät nach einem der vorherigen Ansprüche, dadurch gekennzeichnet, daß die Magazinkästen (82) auf einer umlaufenden Bewegungsbahn verstellbar sind, die vorzugsweise durch ein umlaufendes Förderband (133) gebildet ist.

17. Gerät nach einem der vorherigen Ansprüche, dadurch gekennzeichnet, daß der Boden (87) des Magazinkastens (82) in dessen Magazinstellung am Gerät (2) im wesentlichen in der Ebene der Leiterplatte (4) angeordnet ist.

18. Gerät nach einem der vorherigen Ansprüche, dadurch gekennzeichnet, daß die Kammern an vorzugsweise untereinander gleichen abnehmbaren Magazinkästen (82) ausgebildet sind.

## Claims

1. Apparatus (2) for mounting and/or soldering or cementing of electronic components (15), in particular SMD components, on circuit boards (4), having a first carrier (3) for at least one circuit board (4), having a second carrier (12, 18) for the component (15), and having a magazine (14) for the components (15) that has chambers (82) for receiving the components (15), the second carrier (12, 18) and the magazine (14) being displaceable relative to one another,
characterised in that,
the chambers (82) can be opened and closed by a lid (83) having a fastening mechanism (89) and the fastening mechanism (89) can be opened by the carrier (12, 18) for the component (15).

2. Apparatus according to claim 1,
characterised in that,
the lid (82) can be latched in its fastened position by a latch member (91) that can be moved out of its latched position by the carrier (12, 18).

3. Apparatus according to claim 1 or 2,
characterised in that,
the first carrier (3) and the second carrier (12, 18) are displaceable relative to one another parallel to the plane of the circuit board (4) and transverse thereto.

4. Apparatus according to any preceding claim,
characterised in that,
the latch member (91) can be moved out of its latched position by a vertical movement of the second carrier (12, 18).

5. Apparatus as claimed in claim 4,
characterised in that,
the latch member (91) has, for its operation, an inclined face (93) accessible from above.

6. Apparatus according to any of claims 2 to 5,
characterised in that,
the latch member (91) is movable substantially horizontally.

7. Apparatus according to any preceding claim,
characterised in that,
the chambers are formed in removable and preferably like magazine boxes (82).

8. Apparatus according to claim 7,
characterised in that,
the magazine boxes (82) can be fixed on a further carrier (14, 21) on the apparatus (2), preferably by clamping or latching.

9. Apparatus according to claim 8,
characterised in that,
preferably a plurality of magazine boxes (82) can be fixed on a carrier part, in particular a carrier rail, that can be fixed on the further carrier (81).

10. Apparatus according to claim 9,
characterised in that,
the carrier part can be fixed on the further carrier (14, 81) by latching or clamping.

11. Apparatus (2) for mounting and/or soldering or cementing of electronic components (15), in particular SMD components, on circuit boards (4), having a first carrier (3) for at least one circuit board (4), having a second carrier (12, 18) for the component (15), and having a magazine (131) for the components (15) that has chambers for receiving the components (15), the second carrier (12, 18) and the magazine (131) being displaceable relative to one another, or apparatus (2) according to any preceding claim,
characterised in that,
the chambers are formed by magazine boxes (82) with a lid (83) that can be opened and closed by a fastening mechanism (89),
in that the magazine boxes (82) can be moved on a track (133) into a use position (132),
and in that a mechanism for opening (124) the lid (83) of the relevant magazine box (82) is provided in the use position (122) thereof.

12. Apparatus according to claim 11,
characterised in that,
in the use position the lid (83) opens automatically.

13. Apparatus according to any preceding claim,
characterised in that
the lid is spring biassed towards its open position.

14. Apparatus according to any preceding claim,
characterised in that,
the lid (83) can be latched in its fastened position.

15. Apparatus according to any preceding claim,
characterised in that,
the lid is a hinged lid.

16. Apparatus according to any preceding claim,
characterised in that,
the magazine boxes (82) are displaceable on a circulating track which is preferably formed by a circulating conveyor belt (133).

17. Apparatus according to any preceding claim,
characterised in that,
the bottom (87) of the magazine box (82), in the magazine position thereof in the apparatus (2), is arranged substantially in the plane of the printed circuit board (4).

18. Apparatus as claimed in any preceding claim,
characterised in that,
the chambers are formed in removable and preferably like magazine boxes (82).

## Revendications

1. Appareil (2) pour le montage et/ou le soudage ou le collage de composants (15) électroniques, en particulier de composants montés en surface (CMS), sur des cartes à circuit imprimé (4), comportant un premier support (3) pour au moins une carte à circuit imprimé (4), un deuxième support (12, 18) pour le composant (15) et un magasin (14) pour les composants (15), lequel magasin comporte des compartiments (82) destinés à recevoir les composants (15), le deuxième support (12, 18) et le magasin (14) pouvant être déplacés l'un par rapport à l'autre,
caractérisé par le fait
que les compartiments (82) comportent un couvercle (83) avec un mécanisme de fermeture (89) qui peut être ouvert ou fermé et par le fait que le mécanisme de fermeture (89) est ouvert par le support (12, 18) pour le composant (15).

2. Appareil selon la revendication 1, caractérisé par le fait que le couvercle (82) peut être encliqueté en position fermée au moyen d'un organe d'encliquetage (91) qui peut être dégagé de sa position d'encliquetage par le support (12, 18).

3. Appareil selon la revendication 1 ou 2, caractérisé par le fait que le premier support (3) et le deuxième support (12, 18) peuvent être déplacés l'un par rapport à l'autre parallèlement au plan de la carte à circuit imprimé (4) et transversalement audit plan.

4. Appareil selon l'une des revendications précédentes, caractérisé par le fait que l'organe d'encliquetage (91) peut être dégagé de sa position d'encliquetage par un déplacement vertical du deuxième support (12, 18).

5. Appareil selon la revendication 4, caractérisé par le fait que l'organe d'encliquetage (91) présente pour son actionnement une surface inclinée (93) accessible par le dessus.

6. Appareil selon l'une des revendications 2 à 5, caractérisé par le fait que l'organe d'encliquetage (91) peut être déplacé sensiblement horizontalement.

7. Appareil selon l'une des revendications précédentes, caractérisé par le fait que les compartiments sont aménagés dans des boîtes (82) de magasin amovibles de préférence identiques entre elles.

8. Appareil selon la revendication 7, caractérisé par le fait que les boîtes de magasin (82) peuvent être fixés sur un support (14, 81) supplémentaire sur l'appareil (2), de préférence par pincement ou par encliquetage.

9. Appareil selon la revendication 8, caractérisé par le fait que de préférence plusieurs boîtes de magasin (82) peuvent être fixées sur un élément porteur, en particulier une barre porteuse qui elle-même peut être fixée sur le support (81) supplémentaire.

10. Appareil selon la revendication 9, caractérisé par le fait que l'élément porteur peut être fixé sur le support (81) supplémentaire par encliquetage ou par pincement.

11. Appareil (2) pour le montage et/ou le soudage ou le collage de composants (15) électroniques, en particulier de composants montés en surface (CMS), sur des cartes à circuit imprimé (4), comportant un premier support (3) pour au moins une carte à circuit imprimé (4), un deuxième support (12, 18) pour le composant (15) et un magasin (131) pourvu de compartiments pour les composants (15), le deuxième support (12, 18) et le magasin (131) pouvant être déplacés l'un par rapport à l'autre, ou appareil (2) selon l'une des revendications précédentes,
caractérisé par le fait
que les compartiments sont constitués par des boîtes de magasin (82) pourvues d'un couvercle (83) qui est ouvert et fermé par un mécanisme de verrouillage (89), par le fait que les boîtes de magasin (82) peuvent être amenées dans une position d'utilisation (132) sur une trajectoire de déplacement (133) et par le fait qu'il est prévu dans la position d'utilisation (132) de chaque boîte de magasin (82) un mécanisme d'ouverture (124) du couvercle (83).

12. Appareil selon la revendication 11, caractérisé par le fait que, dans la position d'utilisation, le couvercle (83) s'ouvre automatiquement.

13. Appareil selon l'une des revendications précédentes, caractérisé par le fait que le couvercle est précontraint dans sa position d'ouverture au moyen d'une force de rappel élastique.

14. Appareil selon l'une des revendications précédentes, caractérisé par le fait que le couvercle (83) peut s'encliqueter dans sa position fermére.

15. Appareil selon l'une des revendications précédentes, caractérisé par le fait que le couvercle est un couvercle à charnière.

16. Appareil selon l'une des revendications précédentes, caractérisé par le fait que les boîtes de magasin (82) peuvent être déplacées sur une trajectoire fermée, qui est constituée de préférence par une bande transporteuse (133) sans fin.

17. Appareil selon l'une des revendications précédentes, caractérisé par le fait que lorsque la boîte de magasin (82) occupe la position de magasin sur l'appareil (2), le fond (87) de ladite boîte de magasin est situé sensiblement dans le plan de la carte à circuit imprimé (4).

18. Appareil selon l'une des revendications précédentes, caractérisé par le fait que les compartiments sont agencés dans des boîtes de magasin (82) amovibles de préférence identiques entre elles.
